(19) Europäisches Patentamt
European Patent Office
Office européen des brevets

(11) Veröffentlichungsnummer: **0 229 745**
**B1**

(12) **EUROPÄISCHE PATENTSCHRIFT**

(45) Veröffentlichungstag der Patentschrift: **01.03.89**

(51) Int. Cl.⁴: **C 07 F 7/08**

(21) Anmeldenummer: **87810013.0**

(22) Anmeldetag: **12.01.87**

(54) **Substituierte o-Phthalaldehyde.**

(30) Priorität: **16.01.86 CH 146/86**

(43) Veröffentlichungstag der Anmeldung:
**22.07.87 Patentblatt 87/30**

(45) Bekanntmachung des Hinweises auf die Patenterteilung:
**01.03.89 Patentblatt 89/9**

(84) Benannte Vertragsstaaten:
**AT CH DE FR GB IT LI NL SE**

(56) Entgegenhaltungen:
**EP-A- 0 126 214**
**US-A- 2 641 605**

(73) Patentinhaber: **CIBA-GEIGY AG, Klybeckstrasse 141, CH-4002 Basel (CH)**

(72) Erfinder: **Steinmann, Alfred, Dr., Chemin du Verger 12, CH-1752 Villars-sur-Glâne (CH)**

**EP 0 229 745 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft substituierte o-Phthalaldehyde, Verfahren zu deren Herstellung und die zur Herstellung der substituierten o-Phthalaldehyde verwendeten neuen Di- und Tetrabrom-, -chlor- oder -jodverbindungen.

Aus «Macromolecules», 1969, *2*, Seiten 414-419, geht hervor, dass o-Phthalaldehyd in Gegenwart von bestimmten Katalysatoren polymerisiert werden kann. In der EP-Anmeldung 0 126 214 wird ferner offenbart, dass Polymere des Phthalaldehyds als Photoresist eingesetzt werden können, wobei allerdings 10 Gew.-% Oniumsalze zum Resist zugesetzt werden müssen, damit bei einer Lichtdosis von 2-6 $mJ/cm^2$ diese ausreichend strahlungsempfindlich sind. Ausserdem sind diese Polymere im Sauerstoffplasma nicht stabil.

Es wurde nun gefunden, dass o-Phthalaldehyde, die mindestens einen Substituenten auf Basis von bestimmten Silyl-, Stannyl- oder Germanylgruppen enthalten, ebenfalls polymerisiert werden können, wobei Polymere erhalten werden, die vergleichsweise eine höhere Strahlungsempfindlichkeit bei geringerem Zusatz eines Oniumsalzes und einer kleineren Lichtdosis aufweisen. Zudem weisen diese Polymere eine hohe Sauerstoffplasmaresistenz auf.

Gegenstand der Erfindung sind somit substituierte o-Phthalaldehyde der Formel I

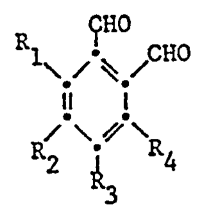
(I),

worin mindestens einer der Reste $R_1$, $R_2$, $R_3$ und $R_4$ für ein $-Q(alkyl)_3$, $-CH_2-Q(alkyl)_3$, $-O-Q-(alkyl)_3$, $-Q(aryl)_3$ oder $-Q(alkylenaryl)_3$ steht, wobei Q für Si, Sn oder Ge steht, die Alkyle 1 bis 12 C-Atome, die Aryle 6 oder 12 C-Ringatome und die Alkylenreste 1-4 C-Atome enthalten, und die übrigen Reste $R_1$ bis $R_4$ je für ein Wasserstoff-, Halogenatom, eine Nitril-, Nitro-, Carboxyl-, Hydroxylgruppe, ein $C_1$-$C_4$-Alkoxy, $C_1$-$C_4$-Alkylthio oder ein Alkoxycarbonyl mit 1-4 C-Atomen im Alkoxyrest stehen.

Vorzugsweise bedeuten in der Formel I ein oder zwei Reste von $R_1$, $R_2$, $R_3$ und $R_4$ je ein Tri($C_1$-$C_4$-alkyl)-silyl, Tri($C_1$-$C_4$-alkyl)-stannyl oder ein Tri($C_1$-$C_4$-alkyl)-germanyl und die übrigen Reste $R_1$ bis $R_4$ je ein Wasserstoffatom.

Insbesondere bedeuten in der Formel I $R_2$ oder $R_3$ ein Tri($C_1$-$C_4$-alkyl)-silyl und die übrigen Reste $R_1$ bis $R_4$ je ein Wasserstoffatom.

Besonders bevorzugte und interessante Verbindungen der Formel I sind solche, worin $R_2$ oder $R_3$ ein Trimethyl- oder Triethylsilyl und die übrigen Reste $R_1$ bis $R_4$ je ein Wasserstoffatom bedeuten.

Die in den definitionsgemässen Resten $R_1$ bis $R_4$ enthaltenen Aryle können gegebenenfalls ein- oder mehrfach substituiert sein, wobei als Substituenten Halogenatome, vorzugsweise Chlor- oder Bromatome, oder Nitrogruppen in Betracht kommen. Geeignete Aryle sind beispielsweise Phenyl, Chlorphenyl, Naphthyl und Chlornaphthyl. Geeignete Alkylenreste in den definitionsgemässen Resten $R_1$ bis $R_4$ sind beispielsweise Methylen oder Ethylen.

Die erfindungsgemässen, substituierten o-Phthalaldehyde der Formel I können hergestellt werden, indem man entweder eine substituierte Dihalogenverbindung der Formel II

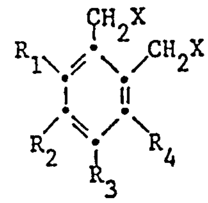
(II),

worin beide X unabhängig voneinander je für ein Brom-, Chlor- oder Jodatom stehen und $R_1$, $R_2$, $R_3$ und $R_4$ die gleiche Bedeutung wie in Formel I haben, in bekannter Weise mit wenigstens äquivalenten Mengen Hexamethylentetramin oder Dimethylsulfoxid zur entsprechenden Verbindung der Formel I oxidiert, oder vorzugsweise eine substituierte Tetrahalogenverbindung der Formel III

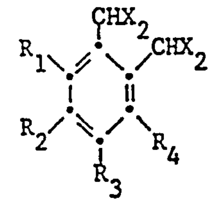
(III),

worin jedes X unabhängig voneinander je für ein Brom-, Chlor- oder Jodatom steht und $R_1$, $R_2$, $R_3$ und $R_4$ die gleiche Bedeutung wie in Formel I haben, in bekannter Weise mit einem Metall- oder Ammoniumsalz einer organischen Säure in wässerigem Medium in Gegenwart eines Phasentransferkatalysators und einer anorganischen Base hydrolysiert, oder mit mindestens äquivalenten Mengen Calciumcarbonat im Wasser oder Kaliumoxalat in Ethanol umsetzt oder mit der 8fachen Molmenge Morpholin umsetzt und das in Zwischenstufe entstehende substituierte Di-(N-morpholino)-1,3-phthalan anschliessend zu einer Verbindung der Formel I hydrolysiert oder mit einer 0,5- bis 15fachen äquivalenten Menge Ameisensäure bei erhöhter Temperatur zur entsprechenden Verbindung der Formel I umsetzt.

Vorzugsweise setzt man zur Herstellung der erfindungsgemässen Verbindungen der Formel I eine substituierte Tetrabromverbindung der Formel III ein und hydrolysiert diese vorzugsweise mit einem Metall- oder Ammoniumsalz einer organischen Säure in wässerigem Medium in Gegenwart eines Phasentransferkatalysators und einer anorganischen Base.

Die oben angegebenen Verfahren für die Umwandlung der Brommethyl- bzw. Dibrommethylgruppen in die Aldehydgruppen sind in der Literatur für ähnliche Verbindungen bereits beschrieben worden. So wird in J. Chem. Soc., *1940*, Seiten 692-702, unter anderem offenbart, dass die Chlormethylgruppe in p-Ethylbenzylchlorid mittels einer äquimolaren Menge Hexamethylentetramin in einer alkoholischen Lösung bei erhöhter Temperatur und unter $CO_2$-Atmosphäre zur Aldehydgruppe oxidiert werden kann.

Die Umwandlung der am aromatischen Ring substituierten Brommethylgruppe in die Aldehydgruppe mittels Dimethylsulfoxid wird in J. Org. Chem., Band 24, *1959*, Seiten 1792-1993, und in J. American Chem. Soc., Band 81, *1959*, Seiten 4113-4114, beschrieben.

Die Überführung einer Tetrahalogenverbindung der Formel III in die erfindungsgemässen, substituierten o-Phthalaldehyde der Formel I durch Hydrolyse mit einem Metall- oder Ammoniumsalz einer organischen Säure in wässerigem Medium in Gegenwart eines Phasentransferkatalysators und einer anorganischen Base kann analog dem in der EP-Anmeldung 0 003 230 offenbarten Verfahren durchgeführt werden, wobei als Metallsalze vorzugsweise Alkali- oder Erdalkalimetallsalze aliphatischer Carbonsäuren, wie Ameisen-, Essig- oder Propionsäure, eingesetzt werden. Als Phasentransferkatalysator verwendet man vorzugsweise Oniumsalze, insbesondere quaternäre Ammonium- oder Phosphoniumsalze, beispielsweise Tetraalkylammoniumsalze oder -phosphoniumsalze, bevorzugt die entsprechenden Halogenide, wie Tetra-n-butylammoniumchlorid oder -bromid oder beispielsweise Tetra-n-butylphosphoniumchlorid oder -bromid. Als anorganische Base verwendet man üblicherweise die Alkalimetall- oder Erdalkalimetallbasen, vorzugsweise die entsprechenden Hydroxide, Hydrogencarbonate und insbesondere Carbonate, wie Magnesium- oder Calciumcarbonat.

Aus J. American Chem. Soc., Band 79, *1957*, Seiten 6540-6542, geht hervor, dass man die am aromatischen Ring substituierte Dibrommethylgruppe durch Oxidation mit Calciumcarbonat in die Aldehydgruppe umwandeln kann, und aus Organic Syntheses, Band 34, *1954*, Seiten 82 bis 84, ist die Umwandlung von Dibrommethylgruppen in Aldehydgruppen mittels Kaliumoxalat bekannt.

Die Überführung von am aromatischen Ring substituierten Dibrommethylgruppen in Aldehydgruppen mittels Morpholin wird in Bulletin de la Soc. Chim. de France, Band 9, *1966*, Seiten 2966-2971, offenbart, und in der DE-OS 30 21 701 wird das Verfahren zur Herstellung von aromatischen Aldehyden durch Umsetzung der entsprechenden Benzalhalogenide mit Ameisensäure bei erhöhter Temperatur beschrieben.

Die Verbindungen der Formeln II und III, die in der Literatur noch nicht beschrieben worden sind, wurden für die Herstellung der erfindungsgemässen Verbindungen der Formel I entwickelt und stellen somit ebenfalls einen Gegenstand der Erfindung dar.

Vorzugsweise bedeuten in den Formeln II und III jedes X unabhängig voneinander je ein Chlor- oder Bromatom, ein oder zwei Reste von $R_1$, $R_2$, $R_3$ und $R_4$ je ein Tri($C_1$-$C_4$-alkyl)-silyl, Tri($C_1$-$C_4$-alkyl)-stannyl oder ein Tri($C_1$-$C_4$-alkyl)-germanyl und die übrigen Reste $R_1$ bis $R_4$ je ein Wasserstoffatom.

Insbesondere bedeuten in den Formeln II und III jedes X ein Chlor- oder Bromatom, $R_2$ oder $R_3$ ein Tri($C_1$-$C_4$-alkyl)-silyl und die übrigen Reste $R_1$ bis $R_4$ je ein Wasserstoffatom.

Besonders interessant sind die Verbindungen der Formel III, insbesondere solche, worin jedes X für ein Bromatom steht, $R_2$ oder $R_3$ ein Trimethyl- oder Triethylsilyl und die übrigen Reste $R_1$ bis $R_4$ je ein Wasserstoffatom bedeuten.

Die Verbindungen der Formeln II und III können analog dem in J. American Chem. Soc., Band 79, *1957*, Seiten 6540-6542, offenbarten Verfahren hergestellt werden, indem man Verbindungen der Formel IV

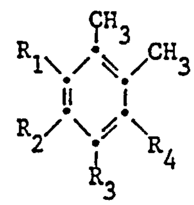

(IV),

worin $R_1$, $R_2$, $R_3$ und $R_4$ die gleiche Bedeutung wie in Formel I haben, mit N-Bromsuccinimid in Gegenwart eines Katalysators, vorzugsweise eines Peroxids, wie Dibenzoylperoxid, zu Verbindungen der Formel II oder III bromiert.

Die Verbindungen der Formel IV sind bekannt und können wie beispielsweise in J. Chem. Soc. *1959*, Seite 3640, oder in J. of Organometallic Chemistry, 84 (1975), 165-175, beschrieben oder in analoger Weise hergestellt werden.

Wie eingangs erwähnt, stellen die erfindungsgemässen Verbindungen der Formel I wertvolle Monomere dar, die polymerisiert als strahlungsempfindliches und sauerstoffplasmaresistentes Resistmaterial eingesetzt werden können.

*Beispiel 1:*

Herstellung von 4-Trimethylsilyl-α,α,α',α'-tetrabromo-xylol

In einem mit Kühler und Rührer ausgerüsteten 1,5-Liter-Sulfierkolben werden unter Stickstoff 100 g (562 mMol) 4-Trimethylsilyl-o-xylol, 400 g (2250 mMol) N-Bromsuccinimid, 1 g Dibenzoylperoxid und 750 ml Tetrachlorkohlenstoff vorgelegt. Man erwärmt das Reaktionsgemisch auf Siedehitze, bis die Reaktion exotherm wird. Das Heizbad wird jetzt entfernt, bis das spontane Sieden abklingt. Danach wird noch etwa eine Stunde bei Siedehitze gerührt. Die gaschromatographische Analyse zeigt, dass kein 4-Trimethylsilyl-o-xylol mehr vorhanden ist. Das Gemisch wird auf 0° C gekühlt und das Succinimid abgetrennt. Das Filtrat wird nun mit 200 ml kalter 5%iger Natronlauge zweimal extrahiert und einmal mit Wasser gewaschen. Die $CCl_4$-Phase wird mit Magnesiumsulfat getrocknet und das $CCl_4$ am Rotationsverdampfer vertrieben.

Man erhält 250 g eines Festkörpers (90% der Theorie), der bei 94° C schmilzt. Durch zweimaliges Umkristallisieren in wenig n-Hexan erhält man weisse Kristalle mit einem Schmelzpunkt von

97° C (Siedepunkt der Verbindung: 138° C/ 0,13 mbar).

*Elementaranalyse:*

| | | | |
|---|---|---|---|
| Berechnet: | C 26,75 | H 2,86 | Br 64,71% |
| Gefunden: | C 26,75 | H 2,87 | Br 64,54% |

$^1$H-NMR-Spektrum (Aceton-$d_6$):

| | | |
|---|---|---|
| $CH_3$–Si | 9 H (s): | 0,4 ppm |
| $Br_2CH$ | 2 H (s): | 7,95 ppm und 7,5 ppm |
| H-aromat. | 3 H (m): | 7,6-7,85 ppm |

*Beispiel 2:*

Herstellung von 4,5-Bis-(trimethylsilyl)-α,α,α',α'-tetrabrom-o-xylol

In einem 1,5-Liter-Sulfierkolben, der mit einem Rührer und einem Kühler versehen ist, werden unter Stickstoff 70 g (280 mMol) 4,5-Bis-(trimethylsilyl)-o-xylol, 224 g (1260 mMol) N-Bromsuccinimid, 5 g Dibenzoylperoxid und 880 ml Tetrachlorkohlenstoff vorgelegt. Man erwärmt die Suspension bis zum selbständigen Sieden. Nach der Exothermie wird noch für etwa drei Stunden am Rückfluss gekocht. Die Suspension wird abgekühlt, vom Succinimid abgetrennt und das Filtrat zweimal mit 10%iger kalter Natronlauge gewaschen. Die getrocknete organische Phase wird vom Lösungsmittel befreit. Der gewonnene Festkörper wird in n-Hexan umkristallisiert. Man erhält 120 g (75%) Festkörper, der bei 157° C schmilzt.

*Elementaranalyse:*

| | | | |
|---|---|---|---|
| Berechnet: | C 29,70 | H 3,92 | Br 56,46% |
| Gefunden: | C 28,90 | H 4,02 | Br 56,38% |

$^1$H-NMR-Spektrum (Aceton-$d_6$):

| | | |
|---|---|---|
| $CH_3$–Si | 18 H (s): | 0,44 ppm |
| $Br_2CH$ | 2 H (s): | 7,65 ppm |
| H-aromat. | 2 H (s): | 8,1 ppm |

*Beispiel 3:*

Herstellung von 4-Trimethylsilyl-o-phthalaldehyd

175 g (355 mMol) 4-Trimethyl-α,α,α',α'-tetrabrom-o-xylol, 119 g Natriumformiat, 72 g Calciumcarbonat, 26 g Tetrabutylammoniumbromid und 150 ml Wasser werden in einem 750-ml-Sulfierkolben mit Rührer vorgelegt. Unter Stickstoff wird das Gemisch auf etwa 100° C erwärmt, wobei das 4-Trimethyl-α,α,α',α'-tetrabrom-o-xylol aufschmilzt.

Dann wird kräftig gerührt, so dass die verschiedenen Phasen gut vermischt werden. Nach etwa 12 Stunden wird auf 0° C abgekühlt und die Mischung mit 400 ml Diethylether extrahiert. Die getrocknete organische Phase wird eingeengt. Der Rückstand wird anschliessend über eine Kieselgel-Kolonne mit Toluol chromatographiert. Nach dem Einengen der Toluolfraktionen erhält man 54 g (61% der Theorie) des reinen 4-Trimethylsilyl-o-phthaldialdehyds.

Dieser wird in etwa dem gleichen Volumen n-Hexan gelöst. Im Kühlschrank bilden sich gelbliche Kristalle, die einen Schmelzpunkt von 38° C haben. Siedepunkt der Verbindung: 98° C/ 0,13 mbar.

*Elementaranalyse:*

| | | | |
|---|---|---|---|
| Berechnet: | C 64,04 | H 6,84 | Si 13,62% |
| Gefunden: | C 63,94 | H 6,96 | Si 13,04% |

$^1$H-NMR-Spektrum (Aceton-$d_6$):

| | | |
|---|---|---|
| $CH_3$–Si | 9 H (s): | 0,36 ppm |
| H-aromat. | 2 H (m): | 8,0 ppm |
| H-aromat. | 1 H (s): | 8,1 ppm |
| CHO | 2 H (s): | 10,6 ppm |

*Beispiel 4:*

Herstellung von 4,5-Bis-(trimethylsilyl)-o-phthaldialdehyd

85 g (150 mMol) 4,5-Bis-(trimethylsilyl)-α,α,α',α'-tetrabrom-o-xylol, 71,5 g Natriumformiat, 35 g Calciumcarbonat, 113 g Tetrabutylammoniumbromid, 175 ml Wasser und 200 ml Toluol werden in einem 750-ml-Sulfierkolben eingebracht und unter Stickstoff wird bei 120° C stark gerührt. Nach 2 Tagen wird auf Raumtemperatur abgekühlt und mit Toluol verdünnt. Die organische Phase wird mit Wasser gewaschen und getrocknet. Das Lösungsmittel wird am Rotationsverdampfer entfernt und der Festkörper in n-Hexan bis zum konstanten Schmelzpunkt umkristallisiert. Man erhält 17 g (40%) einer gelblichen, kristallinen Substanz, die bei 103° C schmilzt.

*Elementaranalyse:*

| | | |
|---|---|---|
| Berechnet: | C 60,38 | H 7,96% |
| Gefunden: | C 59,00 | H 8,05% |

$^1$H-NMR-Spektrum (Aceton-$d_6$):

| | | |
|---|---|---|
| $CH_3$–Si | 18 H (s): | 0,4 ppm |
| H-aromat. | 2 H (s): | 8,3 ppm |
| CHO | 2 H (s): | 10,5 ppm |

*Beispiel 5:*

Polymerisation von 4-Trimethylsilyl-o-phthaldialdehyd

Unter Stickstoff werden 24 g (116 mMol) 4-Trimethylsilyl-o-phthaldialdehyd und 100 ml trockenes Methylenchlorid vorgelegt, in flüssigem Stickstoff abgekühlt und 2 Mol% $BF_3$-Diethylether als Initiator zugesetzt. Danach wird die Lösung im Hochvakuum von Sauerstoff befreit.

In einem Kältebad lässt man unter Stickstoff bei −78° C polymerisieren. Nach wenigen Stunden gibt man bei −78° C zur hochviskosen Lösung 2 ml −78° C kaltes Pyridin/Essigsäureanhydridgemisch (Verhältnis 1:1) hinzu. Man rührt noch 0,5 Stunden bei −78° C, erwärmt auf Raumtemperatur und giesst die Lösung in 1000 ml Methanol, wobei das Polymer sofort ausfällt. Dieses wird abgetrennt und getrocknet. Ausbeute: 23,5 g. Zur Reinigung wird das Polymer nochmals in 300 ml Methylenchlorid gelöst, filtriert und erneut in 1000 ml Methanol ausgefüllt. Das Polymer wird abgetrennt

und bei Raumtemperatur am Hochvakuum getrocknet. Ausbeute: 19,3 g (80% der Theorie).

Das Polymer hat einen Zersetzungspunkt von 156° C. Gelpermeationschromatographische Messungen in Tetrahydrofuran zeigen ein $\overline{M}_w$ von 290 000 und ein $\overline{M}_n$ von 80 000.

*Beispiel 6:*

Polymerisation von 4,5-Bis-(trimethylsilyl)-o-phthaldialdehyd

4 g (14,4 mMol) 4,5-Bis-(trimethylsilyl)-o-phthaldialdehyd werden in einer Ampulle mit 12 ml trockenem Methylenchlorid gelöst. Durch Gefrieren/Auftauen wird am Hochvakuum von Sauerstoff befreit. Über eine Spritze gibt man 2 Mol%, bezogen auf das Monomer, einer $BF_3$-Diethyletheratlösung in Methylenchlorid zur gefrorenen Lösung und lässt dann bei −78° C unter Stickstoff polymerisieren. Nach wenigen Stunden gibt man zur hochviskosen Lösung 1 ml Pyridin, das vorgekühlt war. Dann lässt man die Lösung auf Raumtemperatur erwärmen und fällt das Polymer in Methanol aus. Das weisse Pulver wird getrocknet, erneut in Methylenchlorid gelöst und nochmals in Methanol ausgefällt.

Das weisse Polymerpulver wird am Hochvakuum bei 50° C getrocknet. Man erhält 3,1 g (77%) Polymer.

Das Polymer hat einen Zersetzungspunkt von 170° C. GPC-Messungen in THF zeigen ein $\overline{M}_w$ von 420 000 und ein $\overline{M}_n$ von 180 000.

$^1$H-NMR-Spektrum ($CDCl_3$):

| | | |
|---|---|---|
| $CH_3-Si$ | 18 H (s): | 0,4 ppm |
| H-aromat. | 2 H (s): | 8,2 ppm |
| O<br>\\<br>HC-aromat.<br>/<br>O | 2 H (s): | 10,6 ppm |

## Patentansprüche für die Vertragsstaaten CH, DE, FR, GB, IT, LI, NL, SE

1. Substituierte o-Phthalaldehyde der Formel I

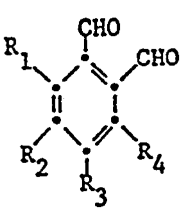

(I),

worin mindestens einer der Reste $R_1$, $R_2$, $R_3$ und $R_4$ für ein $-Q(alkyl)_3$, $-CH_2-Q(alkyl)_3$, $-O-Q(alkyl)_3$, $-Q(aryl)_3$ oder $-Q(alkylenaryl)_3$ steht, wobei Q für Si, Sn oder Ge steht, die Alkyle 1 bis 12 C-Atome, die Aryle 6 oder 12 C-Ringatome und die Alkylenreste 1-4 C-Atome enthalten, und die übrigen Reste $R_1$ bis $R_4$ je für ein Wasserstoff-, Halogenatom, eine Nitril-, Nitro-, Carboxyl-, Hydroxylgruppe, ein $C_1$-$C_4$-Alkoxy, $C_1$-$C_4$-Alkylthio oder ein Alkoxycarbonyl mit 1-4 C-Atomen im Alkoxyrest stehen.

2. o-Phthalaldehyde gemäss Anspruch 1, worin in der Formel I $R_2$ oder $R_3$ ein Tri($C_1$-$C_4$-alkyl)-silyl und die übrigen Reste $R_1$ bis $R_4$ je ein Wasserstoffatom bedeuten.

3. o-Phthalaldehyde gemäss Anspruch 1, worin in der Formel I $R_2$ oder $R_3$ ein Trimethyl- oder Triethylsilyl und die übrigen Reste $R_1$ bis $R_4$ je ein Wasserstoffatom bedeuten.

4. 4-Trimethylsilyl-o-phthalaldehyd und 4,5-Bis-(trimethylsilyl)-o-phthaldialdehyd als Verbindungen der Formel I gemäss Anspruch 1.

5. Verfahren zur Herstellung von o-Phthalaldehyden der Formel I gemäss Anspruch 1, dadurch gekennzeichnet, dass man entweder eine substituierte Dihalogenverbindung der Formel II

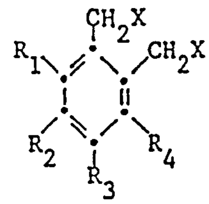

(II),

worin beide X unabhängig voneinander je für ein Brom-, Chlor- oder Jodatom stehen und $R_1$, $R_2$, $R_3$ und $R_4$ die gleiche Bedeutung wie in Formel I haben, in bekannter Weise mit wenigstens äquivalenten Mengen Hexamethylentetramin oder Dimethylsulfoxid zur entsprechenden Verbindung der Formel I oxidiert, oder eine substituierte Tetrahalogenverbindung der Formel III

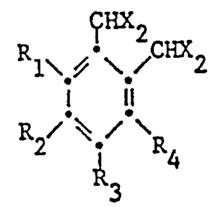

(III),

worin jedes X unabhängig voneinander je für ein Brom-, Chlor- oder Jodatom steht und $R_1$, $R_2$, $R_3$ und $R_4$ die gleiche Bedeutung wie in Formel I haben, in bekannter Weise mit einem Metall- oder Ammoniumsalz einer organischen Säure in wässerigem Medium in Gegenwart eines Phasentransferkatalysators und einer anorganischen Base hydrolysiert, oder mit mindestens äquivalenten Mengen Calciumcarbonat in Wasser oder Kaliumoxalat in Ethanol umsetzt, oder mit der 8fachen Molmenge Morpholin umsetzt und das in Zwischenstufe entstehende substituierte Di-(N-morpholino)-1,3-phthalan anschliessend zu einer Verbindung der Formel I hydrolysiert oder mit einer 0,5- bis 15fachen äquivalenten Menge Ameinsensäure bei erhöhter Temperatur zur entsprechenden Verbindung der Formel I umsetzt.

6. Verfahren gemäss Anspruch 5, dadurch gekennzeichnet, dass man eine substituierte Tetrabromverbindung der Formel III einsetzt und diese mit einem Metall- oder Ammoniumsalz einer organischen Säure in wässerigem Medium in Gegenwart eines Phasentransferkatalysators und einer anorganischen Base hydrolysiert.

7. Di- oder Tetrahalogenverbindungen der Formel II oder III

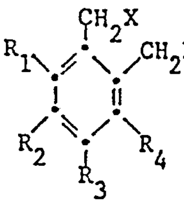 (II) oder 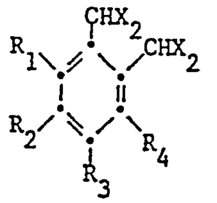 (III),

worin jedes X unabhängig voneinander je ein Brom-, Chlor- oder Jodatom bedeutet und mindestens einer der Reste $R_1$, $R_2$, $R_3$ und $R_4$ für ein $-Q(alkyl)_3$, $-CH_2-Q(alkyl)_3$, $-O-Q(alkyl)_3$, $-Q(aryl)_3$, oder $-Q(alkylenaryl)_3$ steht, wobei Q für Si, Sn oder Ge steht, die Alkyle 1 bis 12 C-Atome, die Aryle 6 oder 12 C-Ringatome und die Alkylenreste 1-4 C-Atome enthalten, und die übrigen Reste $R_1$ bis $R_4$ je ein Wasserstoff-, Halogenatom, eine Nitril-, Nitro-, Carboxyl-, Hydroxylgruppe, ein $C_1$-$C_4$-Alkoxy, $C_1$-$C_4$-Alkylthio oder ein Alkoxycarbonyl mit 1-4 C-Atomen im Alkoxyrest bedeuten.

8. Di- oder Tetrahalogenverbindungen gemäss Anspruch 7, worin in Formeln II und III jedes X unabhängig voneinander je ein Chlor- oder Bromatom, ein oder zwei Reste von $R_1$, $R_2$, $R_3$ und $R_4$ je ein Tri($C_1$-$C_4$-alkyl)-silyl, Tri($C_1$-$C_4$-alkyl)-stannyl oder ein Tri($C_1$-$C_4$-alkyl)-germanyl und die übrigen Reste $R_1$ bis $R_4$ je ein Wasserstoffatom bedeuten.

9. Di- oder Tetrahalogenverbindungen gemäss Anspruch 8, worin in Formeln II und III jedes X für ein Bromatom steht, $R_2$ oder $R_3$ ein Trimethyl- oder Triethylsilyl und die übrigen Reste $R_1$ bis $R_4$ je ein Wasserstoffatom bedeuten.

10. 4-Trimethylsilyl-α,α,α',α'-tetrabrom-o-xylol und 4,5-Bis-(trimethylsilyl)-α,α,α',α'-tetrabrom-o-xylol als Verbindungen der Formel III gemäss Anspruch 8.

## Patentansprüche für den Vertragsstaat: AT

1. Verfahren zur Herstellung von o-Phthalaldehyden der Formel I

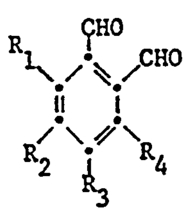 (I),

worin mindestens einer der Reste $R_1$, $R_2$, $R_3$ und $R_4$ für ein $-Q(alkyl)_3$, $-CH_2-Q(alkyl)_3$, $-O-Q(alkyl)_3$, $-Q(alkylenaryl)_3$ steht, wobei Q für Si, Sn oder Ge steht, die Alkyle 1 bis 12 C-Atome, die Aryle 6 oder 12 C-Ringatome und die Alkylenreste 1-4 C-Atome enthalten, und die übrigen Reste $R_1$ bis $R_4$ je für ein Wasserstoff-, Halogenatom, eine Nitril-, Nitro-, Carboxyl-, Hydroxylgruppe, ein $C_1$-$C_4$-Alkoxy, $C_1$-$C_4$-Alkylthio oder ein Alkoxycarbonyl mit 1-4 C-Atomen im Alkoxyrest stehen, dadurch gekennzeichnet, dass man entweder eine substituierte Dihalogenverbindung der Formel II

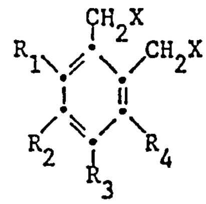 (II),

worin beide X unabhängig voneinander je für ein Brom-, Chlor- oder Jodatom stehen und $R_1$, $R_2$, $R_3$ und $R_4$ die gleiche Bedeutung wie in Formel I haben, in bekannter Weise mit wenigstens äquivalenten Mengen Hexamethylentetramin oder Dimethylsulfoxid zur entsprechenden Verbindung der Formel I oxidiert, oder eine substituierte Tetrahalogenverbindung der Formel III

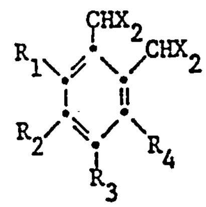 (III),

worin jedes X unabhängig voneinander je für ein Brom-, Chlor- oder Jodatom steht und $R_1$, $R_2$, $R_3$ und $R_4$ die gleiche Bedeutung wie in Formel I haben, in bekannter Weise mit einem Metall- oder Ammoniumsalz einer organischen Säure in wässerigem Medium in Gegenwart eines Phasentransferkatalysators und einer anorganischen Base hydrolysiert, oder mit mindestens äquivalenten Mengen Calciumcarbonat in Wasser oder Kaliumoxalat in Ethanol umsetzt, oder mit der 8fachen Molmenge Morpholin umsetzt und das in Zwischenstufe entstehende substituierte Di-(N-morpholino)-Mengen Calciumcarbonat in Wasser oder Kaliumoxalat in Ethanol umsetzt, oder mit der 8fachen Molmenge Morpholin umsetzt und das in Zwischenstufe entstehende substituierte Di-(N-morpholino)-1,3-phthalan anschliessend zu einer Verbindung der Formel I hydrolysiert oder mit einer 0,5- bis 15fachen äquivalenten Menge Ameisensäure bei erhöhter Temperatur zur entsprechenden Verbindung der Formel I umsetzt.

2. Verfahren gemäss Anspruch 1, dadurch gekennzeichnet, dass man eine substituierte Tetrabromverbindung der Formel III einsetzt und diese mit einem Metall- oder Ammoniumsalz einer organischen Säure in wässerigem Medium in Gegenwart eines Phasentransferkatalysators und einer anorganischen Base hydrolysiert.

3. Verfahren gemäss Anspruch 2, dadurch gekennzeichnet, dass Metallsalz die Alkali- oder Erdalkalimetallsalze aliphatischer Carbonsäuren einsetzt.

## Revendications pour les Etats contractants CH, DE, FR, GB, IT, LI, NL, SE

1. o-Phtalaldéhydes substitués de formule I ci-dessous:

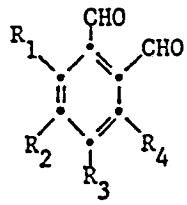 (I),

dans laquelle l'un au moins des radicaux $R_1$, $R_2$, $R_3$ et $R_4$ est un radical $-Q(alkyle)_3$, $-CH_2-Q(alkyle)_3$, $-O-Q-(alkyle)_3$, $-Q(aryle)_3$ ou $-Q(alkylénaryle)_3$, Q désignant Si, Sn ou Ge et les alkyles ayant de 1 à 12 atomes de carbone, les aryles de 6 à 12 carbones dans le cycle et les alkylènes de 1 à 4, et les autres symboles $R_1$ à $R_4$ désignent chacun un atome d'hydrogène ou d'halogène ou un groupe nitrile, nitro, carboxylique, hydroxylique, alcoxy en $C_1$-$C_4$ ou alkylthio en $C_1$-$C_4$ ou encore un groupe alcoxycarbonyle dont l'alcoxy est en $C_1$-$C_4$.

2. o-Phtalaldéhydes selon la revendication 1, dans lesquels, parmi les symboles $R_1$ à $R_4$, $R_2$ ou $R_3$ désigne un radical tri($C_1$-$C_4$-alkyl)silyle et les autres désignent des atomes d'hydrogène.

3. o-Phtalaldéhydes selon la revendication 1, dans lesquels, parmi les symboles $R_1$ à $R_4$, $R_2$ ou $R_3$ désigne un radical triméthylsilyle ou triéthylsilyle et les autres désignent des atomes d'hydrogène.

4. Le 4-triméthylsilyl-o-phtalaldéhyde et le 4,5-bis-(triméthylsilyl)-o-phtaldialdéhyde comme composés de formule I selon la revendication 1.

5. Procédé de préparation de o-phtalaldéhydes de formule I selon la revendication 1, procédé caractérisé en ce que ou bien on oxyde un composé dihalogéné de formule II:

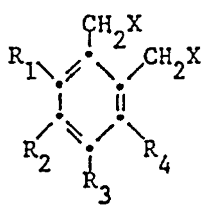 (II),

les deux X désignant chacun, indépendamment l'un de l'autre, un atome de brome, de chlore ou d'iode, de manière connue avec la proportion au moins équivalente d'hexaméthylène-tétramine ou de diméthylsulfoxyde, en composé de formule I correspondant, ou bien on hydrolyse un composé tétrahalogéné de formule III:

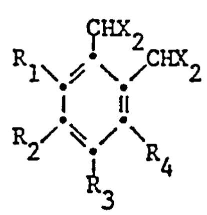 (III),

les symboles X désignant chacun, indépendamment les uns des autres, un atome de brome, de chlore ou d'iode, de manière connue avec un sel de métal ou d'ammonium d'un acide organique en milieu aqueux, en présence d'un catalyseur de transfert de phase et d'une base minérale, ou on le fait réagir avec la proportion au moins équivalente de carbonate de calcium dans de l'eau ou d'oxalate de potassium dans de l'éthanol ou encore avec la proportion huit fois molaire de morpholine, puis on hydrolyse en composé de formule I le di-(N-morpholino)-1,3-phtalane substitué formé dans cette étape intermédiaire, ou avec une proportion de 0,5 à 15 fois équivalente d'acide formique, à chaud, pour former le composé correspondant de formule I.

6. Procédé selon la revendication 5, caractérisé en ce que l'on part d'un composé tétrabromé de formule III que l'on hydrolyse avec un sel de métal ou d'ammonium d'un acide organique en milieu aqueux et en présence d'un catalyseur de transfert de phase et d'une base minérale.

7. Composés dihalogénés ou tétrahalogénés de formules II et III:

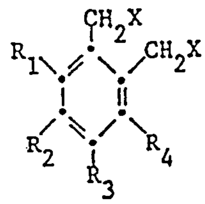 (II) 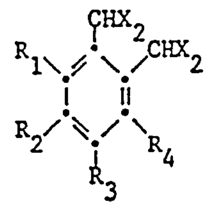 (III),

dans lesquelles les divers symboles X désignent chacun, indépendamment les uns des autres, un atome de brome, de chlore ou d'iode, et parmi les radicaux $R_1$, $R_2$, $R_3$ et $R_4$ l'un au moins est un radical $-Q(alkyle)_3$, $-CH_2-Q(alkyle)_3$, $-O-Q-(alkyle)_3$, $-Q(aryle)_3$ ou $-Q(alkylénaryle)_3$, le symbole Q désignant Si, Sn ou Ge et les alkyles ayant de 1 à 12 atomes de carbone, les aryles de 6 à 12 dans le cycle et les alkylènes de 1 à 4, et les autres $R_1$ à $R_4$ sont chacun un atome d'hydrogène ou d'halogène ou un groupe nitrile, nitro, carboxylique, hydroxylique, alcoxy en $C_1$-$C_4$ ou alkylthio en $C_1$-$C_4$ ou encore un alcoxycarbonyle dont l'alcoxy est en $C_1$-$C_4$.

8. Composés dihalogénés ou tétrahalogénés selon la revendication 7, dans lesquels chaque X, indépendamment des autres, est un atome de chlore ou de brome, et parmi $R_1$, $R_2$, $R_3$ et $R_4$ un ou deux sont un groupe tri($C_1$-$C_4$-alkyl)-silyle, tri($C_1$-$C_4$-alkyl)-stannyle ou tri($C_1$-$C_4$-alkyl)-germanyle et les autres sont des atomes d'hydrogène.

9. Composés dihalogénés ou tétrahalogénés selon la revendication 8, dans lesquels chaque X est un atome de brome et parmi $R_1$ à $R_4$ $R_2$ ou $R_3$ est un groupe triméthylsilyle ou triéthylsilyle et les autres sont des atomes d'hydrogène.

10. 4-Triméthylsilyl-α,α,α',α'-tétrabromo-o-xylène et 4,5-bis-(triméthylsilyl)-α,α,α',α'-tétrabromo-o-xylène comme composés de formule III selon la revendication 8.

**Revendications pour l'Etat contractant: AT**

1. Procédé de préparation de o-phtalaldéhydes de formule I:

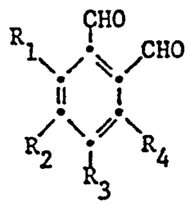 (I),

(dans laquelle l'un au moins des radicaux $R_1$, $R_2$, $R_3$ et $R_4$ est un radical $-Q(alkyle)_3$, $-CH_2-Q(alkyle)_3$, $-O-Q(alkyle)_3$, $-Q(aryle)_3$ ou $-Q(alkylénaryle)_3$, Q désignant Si, Sn ou Ge et les alkyles ayant de 1 à 12 atomes de carbone, les aryles de 6 à 12 carbones dans le cycle et les alkylènes de 1 à 4, et les autres symboles $R_1$ à $R_4$ désignent chacun un atome d'hydrogène ou d'halogène ou un groupe nitrile, nitro, carboxylique, hydroxylique, alcoxy en $C_1$-$C_4$ ou alkylthio en $C_1$-$C_4$ ou encore un groupe alcoxycarbonyle dont l'alcoxy est en $C_1$-$C_4$), procédé caractérisé en ce que ou bien on oxyde un composé dihalogéné de formule II:

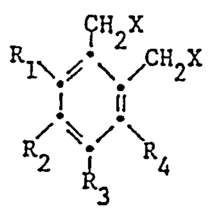 (II),

les deux X désignant chacun, indépendamment l'un de l'autre, un atome de brome, de chlore ou d'iode, de manière connue avec la proportion au moins équivalente d'hexaméthylène-tétramine ou de diméthylsulfoxyde, en composé de formule I correspondant, ou bien on hydrolyse un composé tétrahalogéné de formule III:

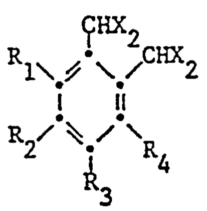 (III),

les symboles X désignant chacun, indépendamment les uns des autres, un atome de brome, de chlore ou d'iode, de manière connue avec un sel de métal ou d'ammonium d'un acide organique en milieu aqueux, en présence d'un catalyseur de transfert de phase et d'une base minérale, ou on le fait réagir avec la proportion au moins équivalente de carbonate de calcium dans de l'eau ou d'oxalate de potassium dans de l'éthanol ou encore avec la proportion huit fois molaire de morpholine, puis on hydrolyse en composé de formule I le di-(N-morpholino)-1,3-phtalane substitué formé dans cette étape intermédiaire, ou avec une proportion de 0,5 à 15 fois équivalente d'acide formique, à chaud, pour former le composé correspondant de formule I.

2. Procédé selon la revendication 1, caractérisé en ce que l'on part d'un composé tétrabromé de formule III que l'on hydrolyse avec un sel de métal ou d'ammonium d'un acide organique en milieu aqueux en présence d'un catalyseur de transfert de phase et d'une base minérale.

3. Procédé selon la revendication 2, caractérisé en ce que le sel de métal est un sel de métal alcalin ou alcalino-terreux d'un acide carboxylique aliphatique.

## Claims for the Contracting States CH, DE, FR, GB, IT, LI, NL, SE

1. A substituted o-phthalaldehyde of formula I

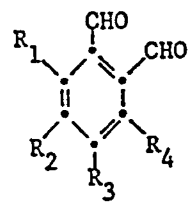 (I),

wherein at least one of the radicals $R_1$, $R_2$, $R_3$ and $R_4$ is a $-Q(alkyl)_3$, $-CH_2-Q(alkyl)_3$, $-O-Q(alkyl)_3$, $-Q(aryl)_3$ or $-Q(alkylene\text{-}aryl)_3$, wherein Q is Si, Sn or Ge, the alkyls contain 1 to 12 carbon atoms, the aryls contain 6 or 12 ring carbon atoms and the alkylene radicals contain 1 to 4 carbon atoms, and each of the remaining radicals $R_1$ to $R_4$ is a hydrogen or halogen atom, a nitrile, nitro, carboxyl or hydroxyl group, a $C_1$-$C_4$-alkoxy, $C_1$-$C_4$-alkylthio or an alkoxycarbonyl having 1 to 4 carbon atoms in the alkoxy radical.

2. An o-phthalaldehyde according to claim 1, wherein $R_2$ or $R_3$ in formula I is a tri($C_1$-$C_{4\,alkyl}$)silyl and each of the remaining radicals $R_1$ to $R_4$ is a hydrogen atom.

3. An o-phthalaldehyde according to claim 1, wherein $R_2$ or $R_3$ in formula I is a trimethylsilyl or triethylsilyl and each of the remaining radicals $R_1$ to $R_4$ is a hydrogen atom.

4. 4-Trimethylsilyl-o-phthalaldehyde or 4,5-bis(trimethylsilyl)-o-phthaldialdehyde as compounds of formula I according to claim 1.

5. A process for the preparation of an o-phthalaldehyde of formula I according to claim 1, which comprises either oxidising a substituted dihalo compound of formula II

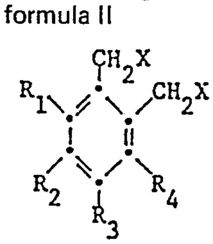 (II)

wherein both Xs independently of one another are a bromine, chlorine or iodine atom and $R_1$, $R_2$, $R_3$ and $R_4$ are as defined for formula I, to the corresponding compound of formula I, in known manner, with at least the equivalent amount of hexamethylenetetramine or dimethylsulfoxide; or hydrolysing a substituted tetrahalo compound of formula III

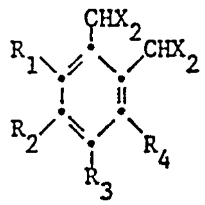

(III)

wherein each X independently of one another is a bromine, chlorine or iodine atom and $R_1$, $R_2$, $R_3$ and $R_4$ are as defined for formula I, in known manner, with a metal or ammonium salt of an organic acid in aqueous medium and in the presence of a phase transfer catalyst and an inorganic base, or by reacting said compound of formula III with at least the equivalent amount of calcium carbonate in water or of potassium oxalate in ethanol, or with the 8-fold molar amount of morpholine, and subsequently hydrolysing the substituted di-(N-morpholino)-1,3-phthalan obtained as intermediate to a compound of formula I, or reacting it with a 0.5- to 15-fold equivalent amount of formic acid, at elevated temperature, to give the corresponding compound of formula I.

6. A process according to claim 5, which comprises using a substituted tetrabromo compound of formula III and hydrolysing this with a metal salt or ammonium salt of an organic acid in aqueous medium in the presence of a phase transfer catalyst and an inorganic base.

7. A di- or tetrahalo compound of formula II or III

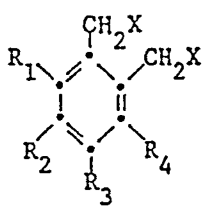

(II) or

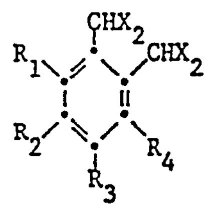

(III)

wherein each X independently of one another is a bromine, chlorine or iodine atom and at least one of the radicals $R_1$, $R_2$, $R_3$ and $R_4$ is a $-Q(alkyl)_3$, $-CH_2-Q(alkyl)_3$, $-O-Q(alkyl)_3$, $-Q(aryl)_3$ or $-Q(alkylene\text{-}aryl)_3$, wherein Q is Si, Sn or Ge, the alkyls contain 1 to 12 carbon atoms, the aryls contain 6 or 12 ring carbon atoms and the alkylene radicals contain 1 to 4 carbon atoms, and each of the remaining radicals $R_1$ to $R_4$ is a hydrogen or halogen atom or a nitrile, nitro, carboxyl or hydroxyl group, a $C_1$-$C_{4\,alkoxy}$, $C_1$-$C_{4\,alkylthio}$ or an alkoxycarbonyl having 1 to 4 carbon atoms in the alkoxy radical.

8. A di- or tetrahalo compound according to claim 7, wherein each X in formulae II and III independently of one another is a chlorine or bromine atom, one or two radicals of $R_1$, $R_2$, $R_3$ and $R_4$ are each a tri($C_1$-$C_4$-alkyl)silyl, tri($C_1$-$C_{4\,alkyl}$)stannyl or a tri($C_1$-$C_{4\,alkyl}$)germanyl and each of the remaining radicals $R_1$ to $R_4$ is a hydrogen atom.

9. A di- or tetrahalo compound according to claim 8, wherein each X in formulae II and III is a bromine atom, $R_2$ or $R_3$ is a trimethylsilyl or triethylsilyl and each of the remaining radicals $R_1$ to $R_4$ is a hydrogen atom.

10. 4-Trimethylsilyl-α,α,α',α'-tetrabromo-o-xylene or 4,5-bis(trimethylsilyl)-α,α,α',α'-tetrabromo-o-xylene as compounds of formula III according to claim 8.

**Claims for the Contracting State: AT**

1. A process for the preparation of an o-phthalaldehyde of formula I

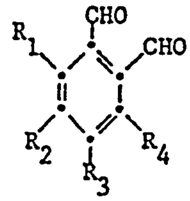

(I)

wherein at least one of the radicals $R_1$, $R_2$, $R_3$ and $R_4$ is a $-Q(alkyl)_3$, $-CH_2-Q(alkyl)_3$, $-O-Q(alkyl)_3$ or $-Q(alkylene\text{-}aryl)_3$, wherein Q is Si, Sn or Ge, the alkyls contain 1 to 12 carbon atoms, the aryls contain 6 to 12 ring carbon atoms and the alkylene radicals contain 1 to 4 carbon atoms, and each of the remaining radicals $R_1$ to $R_4$ is a hydrogen or halogen atom, a nitrile, nitro, carboxyl or hydroxyl group, a $C_1$-$C_4$-alkoxy, $C_1$-$C_{4\,alkylthio}$ or an alkoxycarbonyl having 1 to 4 carbon atoms in the alkoxy radical which comprises either oxidising a substituted dihalo compound of formula II

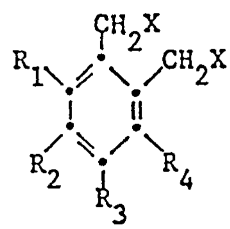

(II)

wherein both Xs independently of one another are a bromine, chlorine or iodine atom and $R_1$, $R_2$, $R_3$ and $R_4$ are as defined for formula I, to the corresponding compound of formula I, in known manner, with at least the equivalent amount of hexamethylenetetramine or dimethylsulfoxide; or hydrolysing a substituted tetrahalo compound of formula III

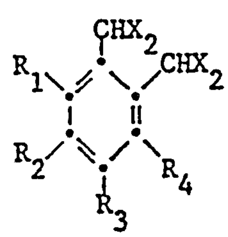

(III)

wherein each X independently of one another is a bromine, chlorine or iodine atom and $R_1$, $R_2$, $R_3$ and $R_4$ are as defined for formula I, in known manner, with a metal or ammonium salt of an organic acid in aqueous medium and in the presence of a phase transfer catalyst and an inorganic base, or by reacting said compound of formula III with at least the equivalent amount of calcium carbonate in

water or of potassium oxalate in ethanol, or with the 8-fold molar amount of morpholine, and subsequently hydrolysing the substituted di-(N-morpholino)-1,3-phthalan obtained as intermediate to a compound of formula I, or reacting it with a 0,5- to 15-fold equivalent amount of formic acid, at elevated temperature, to give the corresponding compound of formula I.

2. A process according to claim 1, which comprises using a substituted tetrabromo compound of formula III and hydrolysing this with a metal salt or ammonium salt of an organic acid in aqueous medium in the presence of a phase transfer catalyst and an inorganic base.

3. A process according to claim 2, which comprises using as metal salt the alkali metal salts or alkaline earth metal salts of aliphatic carboxylic acids.